# EUROPEAN PATENT APPLICATION

(11) **EP 4 779 328 A1**
(43) Date of publication of application: **22.07.2026**
(21) Application number: 25152642.2
(22) Date of filing: 17.01.2025
(51) Int. Cl.: G01R 29/08

(54) **COMPACT AND HIGH-SPEED ELECTROMAGNETIC RADIATION DETECTOR BASED ON A PHOTONIC CIRCUIT**

(71) Applicant: Ecole Polytechnique Fédérale de Lausanne (EPFL), 1015 Lausanne (CH)
(72) Inventor: Gaier, Aleksei, 1018 Lausanne (CH); Benea-Chelmus, Ileana-Cristina, 1112 Échichens (CH)
(74) Representative: Vesterinen, Jussi Tapio

(57) **Abstract**

An electromagnetic radiation detector (2) according to one embodiment of the invention comprises: a light source (11₁) for emitting continuous-wave optical radiation, and an electro-optic modulator (20) exposed to an electromagnetic radiation to be detected and configured to receive the optical radiation. The electro-optic modulator (20) comprises an antenna (22) for collecting the electromagnetic radiation, an optical waveguide (23) extending in the electro-optic modulator (20) to allow the optical radiation to propagate therethrough, and two electrodes (24) extending along the waveguide (23) and coupled to the antenna (22) to enable an electro-optic effect to take place in the waveguide (23) such that the electromagnetic radiation modulates the optical radiation propagating in the waveguide (23). The detector further comprises a photodetector (12) configured to receive the modulated optical radiation and convert the modulated optical radiation into an electrical signal to allow determination of the power of the detected electromagnetic radiation.

## Description

### TECHNICAL FIELD

The present invention relates to a compact and high-speed electromagnetic radiation detector comprising at least a light source, photonic circuit and an optical detector. In particular, the detector is configured to detect micrometre-wave (also known as microwave), millimetre-wave and/or terahertz free-space radiation. The present invention also relates to a corresponding method of operating the detector.

### BACKGROUND OF THE INVENTION

Micrometre-wave, millimetre-wave, and terahertz (THz) radiation detectors are critical components in a wide range of applications, including application relating to wireless communications, radar systems, medical imaging, security screening, and scientific research. These detectors enable the detection and measurement of free-space electromagnetic radiation in the micrometre-wave, millimetre-wave, and terahertz frequency bands, which span from roughly 300 MHz to 10 THz. However, current state-of-the-art detectors for these frequency ranges suffer from several significant limitations that hinder their performance, miniaturisation, and practical deployment in real-world environments.

One of the most prominent challenges with existing micrometre-wave, millimetre-wave, and terahertz detectors is their large physical size. Many traditional detectors, such as bolometers, diodes, and Schottky-barrier detectors, rely on bulky components that require large sensor arrays or intricate optical systems. These large detectors not only occupy significant space but also require complex integration with other system components, making them impractical for compact or portable applications, where size and weight are key constraints.

Another issue that hampers the functionality of conventional radiation detectors is the need for frequent and precise calibration. Many existing detectors exhibit sensitivity to environmental factors, such as temperature fluctuations, power supply variations, and mechanical stress, leading to the degradation of measurement accuracy over time. As a result, detectors must undergo regular recalibration to ensure reliable and consistent performance. This persistent requirement for calibration introduces operational complexity, downtime, and maintenance costs, further limiting the adoption of these detectors in commercial and industrial applications.

In addition to size and calibration challenges, many traditional detectors suffer from slow response times. The physical principles underlying these detectors, such as thermal or electrical detection, typically involve slow dynamics due to thermal inertia, and their large size typically results in an extended time required for electrical charge transport. As a result, many micrometre-wave, millimetre-wave, and terahertz detectors exhibit long response times, making them unsuitable for high-speed applications where real-time detection is essential. This slow response time also limits the ability to capture fast or transient events, further constraining their use in dynamic and high-performance systems.

Moreover, many existing radiation detectors have a broad spectral sensitivity to electromagnetic radiation, ranging from the ultraviolet to the terahertz domain, leading to strong out-of-band crosstalk and saturation by e.g. optical light.

Thus, there is a significant need for novel radiation detectors that overcome at least some of the above-identified challenges, and which would thus be compact, highly accurate, frequency-selective (i.e., they can be designed for a desired frequency band),and would have fast-response time requiring minimal calibration, and which could be seamlessly integrated into modern systems.

### SUMMARY OF THE INVENTION

It is an object of the present invention to overcome at least some of the shortcomings identified above relating to electromagnetic radiation detectors. More specifically, the present invention addresses at least some of the above-identified issues by introducing a novel approach based on a photonics circuit, offering a high-performance solution for micrometre-wave, millimetre-wave, and/or terahertz free-space radiation detection.

According to a first aspect of the invention, there is provided an electromagnetic radiation detector as recited in claim 1.

The proposed detector, which is based on a configuration including a light source, a photonic circuit, and an optical detector, has the following advantages:
(1) very thin and compact structure;
(2) stable operation over many weeks and months, which means that there is no need for recalibrations;
(3) very short response time, having response time in the sub-nanosecond region as opposed to millisecond region, enabling high-speed applications;
(4) specifically sensitive only to desired frequency bands by means of design of the photonic chip, as well as optional optical, terahertz and/or radio-frequency filtering implemented directly within the device package;
(5) plug-and-play capability allowing the detector to be easily plugged for example to an off-the-shelf computing device; and
(6) possibility to upgrade the detector to become a spectrometer and provide the frequency-resolved complex spectrum of a wireless signal by adding a second light source.

According to a second aspect of the invention, there is provided a method for operating an electromagnetic radiation detector as recited in claim 13.

Other aspects of the invention are recited in the dependent claims attached hereto.

### BRIEF DESCRIPTION OF THE DRAWINGS

Other features and advantages of the invention will become apparent from the following description of non-limiting example embodiments, with reference to the appended drawings, in which:
- Figure 1 schematically shows a detector system where the teachings of the present invention may be implemented;
- Figure 2 is a block diagram illustrating an electromagnetic radiation detector according to a first embodiment of the present invention;
- Figure 3 is a block diagram illustrating an electromagnetic radiation detector according to a second embodiment of the present invention;
- Figure 4 shows possible components, such as different antennas, of an electro-optic modulator used in the detector of the present invention;
- Figure 5 is a flowchart illustrating the method of operating the detector in a power meter mode when the output signal is a digital signal;
- Figure 6 is a flowchart illustrating the method of operating the detector in a power meter mode when the output signal is an analogue signal;
- Figure 7 is a flowchart illustrating the method of operating the detector in a spectrometer mode when the output signal is a digital signal;
- Figure 8 is a flowchart illustrating the method of operating the detector in a spectrometer mode when the output signal is an analogue signal; and
- Figure 9 shows some experimental results.

### DETAILED DESCRIPTION OF EMBODIMENTS OF THE INVENTION

Some embodiments of the present invention are explained in the following in more detail. As utilised herein, "and/or" means any one or more of the items in the list joined by "and/or". As an example, "x and/or y" means any element of the three-element set {(x), (y), (x, y)}. In other words, "x and/or y" means "one or both of x and y." As another example, "x, y, and/or z" means any element of the seven-element set {(x), (y), (z), (x, y), (x, z), (y, z), (x, y, z)}. In other words, "x, y and/or z" means "one or more of x, y, and z." The term "comprise" is used herein as an open-ended term. This means that an object encompasses all the elements listed, but may also include additional, unnamed elements. Thus, the word "comprise" is interpreted by the broader meaning "include", "contain" or "comprehend". Identical or corresponding functional and structural elements which appear in the different drawings are assigned the same reference numerals. Different drawings are not necessarily drawn to scale. It is to be noted that the use of words "first", "second" and "third", etc. may not imply any kind of particular order or hierarchy unless this is explicitly or implicitly made clear in the context.

Some definitions that are useful for understanding the teachings of the present invention are given in the following.
- An optical signal is optical radiation that preferably contains one single frequency. In time domain, according to the present invention it is a continuous wave as opposed to a series of pulses.
- A spectral filter is an optical component, in a fibre, on-chip or in free space, which is configured to transmit or reflect only certain well-defined frequency components. Spectral filters used in the present invention may be dichroic mirrors, resonant metasurfaces, dielectric coatings, directional couplers, or any other chromatic components. The filter can also be of electronic nature and comprised within an electronic circuit, or digital, implemented after the analogue-to-digital conversion.
- An electro-optic modulator (EOM) is an electro-optic component in a fibre or on-chip, which is configured to change the phase, intensity and/or polarisation of light upon electric stimuli. EOMs are components that change optical signal properties when electronic signals are applied.
- An antenna is a passive component, which can collect or emit electromagnetic radiation, such as micrometre-wave, millimetre-wave or terahertz radiation, from or into free space. As used in the present invention, antennas may be metallic antennas (such as dipole antennas, bow tie antennas, lumped elements, log-spiral antennas, Yagi-Uda antennas, and/or Vivaldi antennas) and/or dielectric antennas.
- Micrometre-wave frequency band or range refers to electromagnetic waves with frequencies comprised between 300 MHz and 30 GHz.
- Millimetre-wave frequency band or range refers to electromagnetic waves with frequencies comprised between 30 GHz and 300 GHz.
- Terahertz frequency band or range refers to electromagnetic waves with frequencies comprised between 300 GHz and 10 THz.
- A waveguide is a component that guides optical signals on-chip, composed of a core and a cladding arrangement. A waveguide as used in the present invention may be a rib, ridge, metal-infused, or slab waveguide. A non-linear waveguide as used in the present invention is an optical waveguide structure that exhibits non-linear optical properties, meaning that the behaviour of light passing through the waveguide is influenced by the detected electromagnetic radiation. In contrast, linear waveguides do not exhibit such radiation-dependent effects. In a non-linear waveguide, the refractive index of the material changes in response to the detected electromagnetic radiation. This change in refractive index can result in various non-linear optical phenomena, including frequency conversion, phase modulation, intensity modulation, or polarisation modulation. Non-linear waveguides are typically fabricated using materials with high non-linear susceptibility. The waveguide structure confines and guides the light within a certain region, allowing for efficient interaction between the light and the non-linear material.
- A fibre is a passive or active optical component that guides light. As used in the present invention, a fibre may be a single-mode fibre, a multi-mode fibre, a non-linear fibre, a dispersion-compensating fibre, an amplifying fibre (fibre with rare-earth ion dopants to contain gain) or any combination of any of the above where each component may have any length, and where the order of the corresponding fibre pieces can be any of the possible permutations.
- A transmission line is a specialised structure designed to conduct electromagnetic waves in a contained manner. For this purpose, the transmission lines in the present invention use two parallel or substantially parallel elongated electrodes having a gap therebetween.
- A photonic or optical circuit is a functioning circuit comprising one or more photonic components, a transmission line, an optical waveguide, one or more antennas, and optionally one or more other elements. In the examples below, the photonic circuits are photonic integrated circuits (PICs) forming a microchip. This technology detects, transports, and processes light. Photonic circuits use photons (or particles of light) as opposed to electrons that are used by electronic integrated circuits. The major difference between the two is that a photonic circuit provides functions for information signals imposed on optical wavelengths typically in the visible spectrum or near-infrared (850 nm - 1650 nm).
- An integrated circuit, also known as a microchip or simply chip, is a small electronic device made up of multiple interconnected electronic components, such as transistors, resistors, and capacitors. These components are etched onto a small piece of semiconductor material, usually silicon.
- An electromagnetic radiation detector is a device that senses and measures electromagnetic radiation across a range of wavelengths or frequencies, converting the incident radiation into a measurable signal in the form of an electrical output. In power meter mode, the detector quantifies the total intensity or power of the radiation, providing a reading that represents the energy flux. In spectrometer mode, the detector additionally resolves the radiation into its component wavelengths or frequencies, enabling the analysis of the radiation's spectral composition. The detector's output can be used to assess both the intensity and the spectral characteristics of the radiation depending on the measurement mode employed.

Detection of free-space radiation in the frequency range of 40 GHz - 1000 GHz holds the potential for diverse applications, such as 6G communication protocols, spectroscopy, remote sensing systems, etc. However, efficient detection with compact, high-speed, and easily handled devices operating at these frequencies is highly challenging. Integrated photonics circuit technology offers a solution to this problem by using highly scaled, custom-tailored, and power-efficient circuits in which the electro-optic effect is used for sensitive detection of electromagnetic free-space radiation, in particular micrometre-wave, millimetre-wave and/or terahertz free-space radiation. Such a design is robust against temperature variations, is high-speed compatible, millimetre-sized, and has a custom-tailored sensitivity bandwidth, enabling plug-and-play detectors that suppress out-of-band sensitivity. This kind of detector can be used in constrained spaces and under diverse operational conditions without the need for continuous recalibration. Furthermore, this kind of detector may be used in various fields of science, such as optics, photonics, radar applications, wireless communications, biology, mechanics, and quantum technology, for instance for spectroscopy, communication protocols, metrology, and semiconductor fabrication quality control systems.

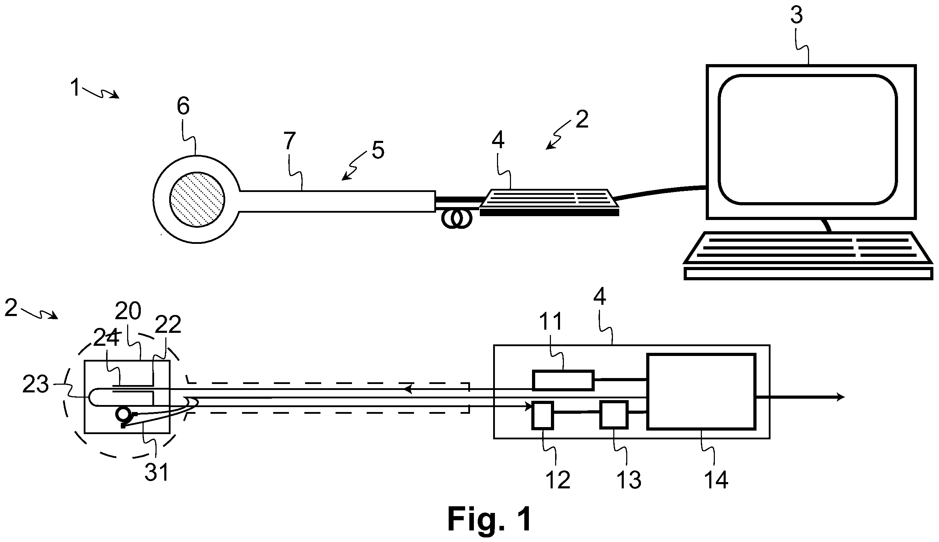

The upper part of Figure 1 shows an example detector system 1, where the teachings of the present invention may be applied, while the bottom part of Figure 1 shows an example detector device 2, or simply detector. As can be seen, the detector system 1 comprises two main components or elements, namely the detector 2 and a computing device 3 or computer. The computing device 3 may be a lap-top computer, a desktop computer, a tablet computer, a smartphone, or any other suitable computing device able to carry out data processing. In the configuration of Figure 1, the detector 2 in turn comprises two main components, namely a console 4, and a handheld portable sensor device 5 including in this example a sensor or detector head 6 and a handle 7. As explained later in more detail, all components or substantially all components of the system are packaged within the sensor head 6, or the computing device 3, including one or more optical radiation sources, an optical detector, which is also called a photodetector, a filter, and an amplifier. However, in another configuration, the computing device 3 could be merged with the detector 2 to form a single ultra-compact device.

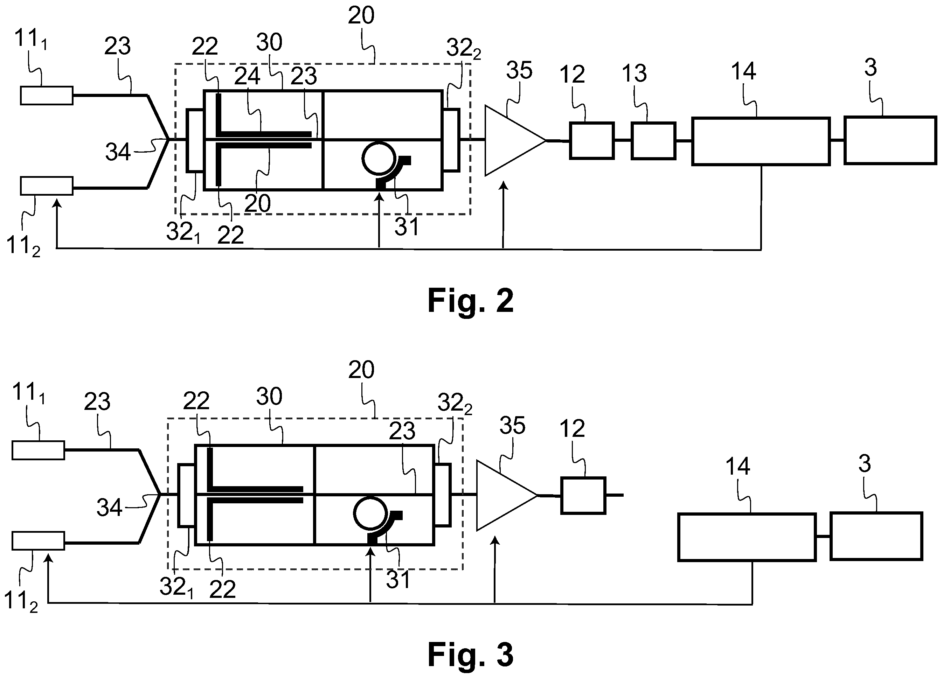

In the example shown in Figure 1, the console 4 comprises a light source 11, which in this case is a laser device, an optical detector 12, an analogue-to-digital converter 13, which is not required in all implementations of the present invention, and a control board 14. The sensor head 6 has a sensor or detector area comprising a photonic circuit 20, which in this case is a photonic integrated circuit (PIC) or a photonic chip. The cm-size photonic circuit 20 has a large-aperture on-chip antenna 22 as is shown for instance in Figures 2, 3, and 4, and which captures the electromagnetic radiation, such as terahertz radiation, that is being analysed. The photonic circuit 20 exploits the Pockels effect, which allows the electric field of an incoming signal to be coherently transferred to the intensity/phase of an optical signal. The on-chip antenna 22 facilitates the coupling of the free-space electromagnetic radiation to a submillimetre-long transmission line that is patterned on the chip and supports the propagation of the terahertz mode or another frequency mode. An optical waveguide 23 placed in between contacts 24, i.e., electrodes, of a transmission line is used to deliver the signal as explained later in more detail. Engineering the on-chip geometry allows the detection efficiency to be maximised by achieving phase-matched terahertz-optical frequency conversion, or another frequency conversion depending on the frequency of the electromagnetic radiation to be detected. The optical signal is then read out, optionally after further processing it, providing either an analogue or a digital output signal, as illustrated in Figure 2 and Figure 3, respectively.

Depending on the implementation as will be explained later, there are either one or two (or possibly more) sources of optical radiation that are coupled by for example through an optical fibre or through free space to an optical waveguide that is patterned on the photonic circuit. They can be any of the following: 1) pigtailed laser diodes, 2) sources of laser radiation based on other integrated photonic circuits, 3) super luminescent diodes, 4) vertical-cavity surface-emitting lasers (VCSELs), 5) free-space packaged lasers, 6) miniaturised femtosecond lasers. The control board 14 controls the optical radiation sources (which will be described below) by applying the necessary voltages and currents and maintaining a fixed temperature.

Figure 2 shows a more detailed schematic illustration of the detector 2, in which the output signal of the detector is a digital signal. As can be seen in Figure 2, the detector in this example comprises two light sources 11, namely a first light source 11₁ and an optional second light source 11₂. It is to be noted that the second light source is only required if the detector is used as a spectrometer as will be explained later.

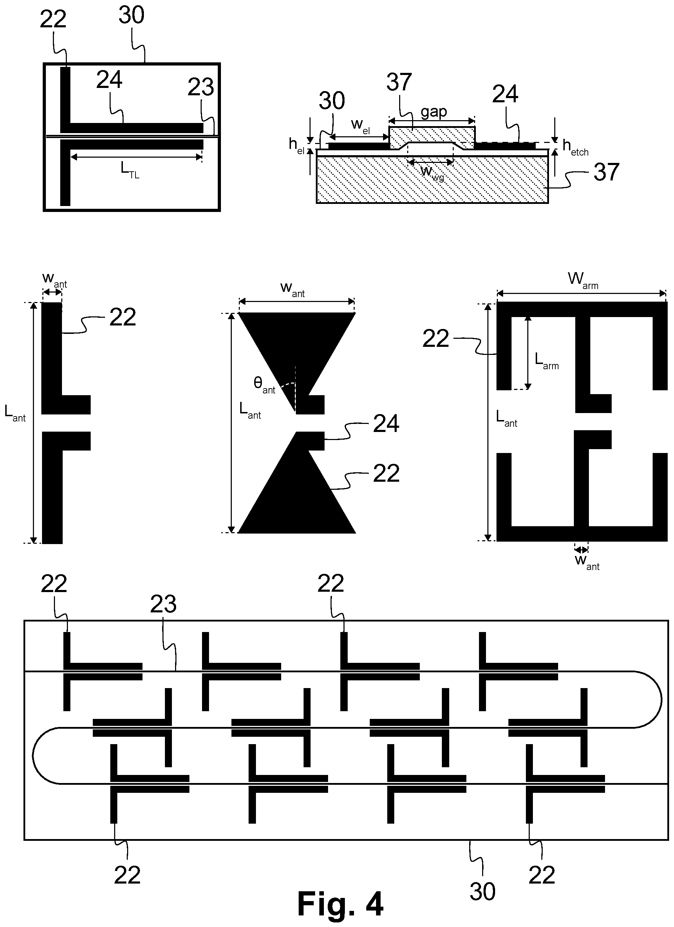

The photonic circuit 20 contains two main parts, namely a wireless electro-optic modulator (EOM) 30 and an optional tuneable optical filter 31. The structure and operation principle of the EOM is described in the following. The EOM 30 comprises an optical waveguide 23 and electrodes 20, which may be for instance made of metal, placed around or longitudinally along the waveguide, as shown in Figure 2. The electrodes form the transmission line for the electromagnetic radiation with the length ranging from 0.1 mm to 10 mm. The width or cross-sectional diameter of the optical waveguide is in the range of 0.5 µm to 2 µm, and the etching height varies between 0.3 µm and 0.6 µm. The gap or distance between the two electrodes is in the range of 2 µm to 10 µm. The width of the electrodes lies in the range between 1 µm and 10 µm, and the height of the electrodes lies in the range of 0.1 µm and 1 µm. In this example, gold was chosen as an electrode material. However, other electrically conductive materials, such as other metals, may be used to make the electrodes. In particular, the electrodes may be made or primarily made of a metal selected from a group consisting of Al, Cu, Ag, Cr, Ru, Ti, Be, W, Au, Pt, Ta, Mo, Nb, NbN, and Ni. One end of the transmission line is terminated with an antenna 22, such as a dipole antenna, bow tie antenna, or LC antenna. Their sketches are presented in Figure 4. These antennas couple the free-space electromagnetic radiation to be detected into the on-chip transmission line. It is to be noted that the photonic circuit 20 may contain a plurality of antenna transmission line devices where the optical waveguide 23 passes through several antennas, as presented in Figure 4.

The optical filter 31 is an optional component of the detector used for spectral filtering of the optical signal. This filter is tuneable, i.e., the control board 14 is configured to tune its optical transmission/reflection characteristics. The filter may be implemented directly on the chip with microring resonators, interferometers (e.g., Mach-Zehnder interferometer), Bragg gratings, or with the dispersion-engineered nonlinearity of the optical waveguide. The filter may instead or additionally be realised by external fibre-based components (such as fibre Bragg grating filters) or other free-space optical components.

The photonic circuit 20 in this example also comprises a first photonic circuit interface 32₁ at the input of the photonic circuit, and a second photonic circuit interface 32₂ placed after the photonic circuit, in this case at the output of the optical filter 31. The photonic circuit interface realises the coupling of the optical radiation into or out of the photonic circuit. The optical radiation from the light sources 11₁, 11₂ is coupled into the photonic circuit 20 either through optical waveguides 23 or optical fibres, which are assembled with the integrated photonic circuit via epoxy die bonding or optical wire bonding, or through free-space optical components such as microlenses, microscope objectives, anti-reflection coatings, if the optical radiation reaches the photonic circuit through open space.

If two light sources are provided, then the detector also optionally comprises a wavelength division multiplexer (WDM) 34, which combines the optical radiation emitted by the two light sources into one single optical waveguide. It can be implemented with either fibre-based components or with integrated photonics components, such as Y-combiners, multimode interferometers, evanescent couplers, inverse-designed dichroic couplers or resonators. It is to be noted that the WDM 34 is not required in all implementations. For example, the optical radiation from the second light source 11₂ may not have to propagate through the photonic circuit 20. In fact, the optical radiation from the second light source 11₂ may be routed directly to the optical detector 12. It could be routed from the second light source directly to the photodetector, or alternatively, it could travel first through some waveguide on the photonic circuit 20 and then reach the optical detector.

In this example, there is provided an optional optical amplifier 35 between the second photonic circuit interface 32₂ and the optical detector 12. The optical amplifier 35 is optionally used to amplify the optical signals. This component may either be a fibre-based system, such as an erbium-doped fibre amplifier (EDFA) or on-chip, using non-linear optical effects.

The optical detector 12 is placed on the path of the optical signal after the amplifier 35 and is used to convert the optical signals into electrical signals (i.e., radio frequency (RF) signals) represented in this case by voltage. The optical detector 12 may be implemented based on on-chip integrated/free-space/fibre photodiodes (including balanced photodiodes), optical detectors based on superconducting nanowires, or graphene-based detectors. After the optical detector, one or more additional electrical components may optionally be used, such as direct current (DC) blocks, a low-pass filter, a high-pass filter, a band-pass filter, and/or a low-noise amplifier.

The analogue-to-digital converter (ADC) 13 is in this case provided between the optical detector 12 and the control board 14 and is used to transform the analogue RF signals into digital signals, which can then be read out by the control board 14. The control board is used to (i) read the measured digital signals, and (ii) to establish feedback to one or more hardware components of the detector, such as the light sources 11₁, 11₂, the tuneable filter 31, and the optical amplifier 35. A microcontroller, field-programmable gate array (FPGA), or application-specific integrated circuit (ASIC) may be used to implement the control board 14. The measured signal received from the control board 14 is then used by the computing device 3 having a user interface to send information about the measured signal(s) to the user. The user interface may be implemented with a graphical user interface, which may be a liquid crystal display or another type of screen.

Figure 3 shows a more detailed schematic illustration of the detector 2, in which the output signal of the detector is an analogue signal. As can be seen in Figure 3, the detector in this example comprises two light sources 11, namely a first light source 11₁ and an optional second light source 11₂. However, here again, the second light source is only required if the detector is used as a spectrometer as will be explained later. The main difference between the two configurations of Figures 2 and 3 is the provided output signal: in the first configuration of Figure 2, it is the digital signal post-processed by the control board 14, and in the second configuration of Figure 3, it is an analogue signal from the optical detector 12.

The detector 2 can operate in two modes, namely in power meter mode and in spectrometer mode. In the power meter mode, the detector is utilised to measure the power of the detected electromagnetic radiation that shines onto the detector head 6. In this mode, a single-mode optical signal (i.e., the laser signal) is transmitted through the chip and modulated by the electromagnetic signal, leading to a modulation of the phase of the optical signal. The power of the incident electromagnetic wave (radiation) can be then retrieved in two ways: either by first filtering the original optical signal with the tuneable optical filter 31 and then reading out the remaining power at the optical detector 12, or, alternatively, by first detecting the entire optical signal at the optical detector 12 and then filtering electronically the RF signal resulting from the optical detector 12. The aim of the filtering operation is to suppress the carrier frequency component of the original optical signal generated by the first light source 11₁. In other implementations it is possible to implement the detector with no filtering. In all cases, the electrical signal is proportional to the power of the detected electromagnetic radiation, and its magnitude is read out to determine the power of the detected incident electromagnetic beam or radiation. In implementations with a digital output signal, the optical detector output is digitised using the ADC 13. In implementations with an analogue output signal, the optical detector output is directly made available to the user via an electrical connector.

In the spectrometer mode, the device is utilised to measure the complex power spectrum of the electromagnetic radiation to be detected. In other words, in this mode, the detector 2 measures both the power of the detected electromagnetic radiation and its frequency. In this mode, the first and second light sources 11₁, 11₂ emit radiation at a first frequency f₁ and at a second, different frequency f₂, respectively. This radiation is transmitted through the photonic circuit 20, such that each radiation or frequency component is modulated by the detected electromagnetic radiation signal, leading to a modulation of their phases. The tuneable filter 31 is used to suppress, to the extent possible, the optical radiation at frequency f₁. Thus, the output optical spectrum contains the following spectral components: f₁-f_{sig}, f₁, f₁+f_{sig}, f₂-f_{sig}, f₂, f₂+f_{sig}, where f_{sig} is the frequency of the detected electromagnetic radiation signal. Frequency f₂ of the optical radiation from the second light source 11₂ is then tuned such that the difference f_{diff}=|f₂ - (f₁+f_{sig})| is lying within the bandwidth of the optical detector 12. Thus, the frequency of the optical radiation from the first light source 11₁ is kept constant or substantially constant, while the frequency from the second light source 11₂ is preferably varied, i.e., it is swept across a given frequency band. Then, the analogue signal of the optical detector 12 contains the beating frequency of these spectral components at frequency f_{diff}. Since both frequencies f₁ and f₂ are known, frequency f_{sig} is then determined as follows: f_{sig}≈|f₂ - f₁| with an uncertainty of f_{diff}. The power of the detected electromagnetic radiation signal in this case is proportional to the amplitude of the beating signal measured from the optical detector 12. The phase of the detected electromagnetic radiation is given by the phase of the beating signal. Collectively, the frequency, intensity and phase information of the detected electromagnetic radiation allows the complex spectrum of the detected electromagnetic radiation to be determined. In implementations with a digital output signal, the optical detector output is digitised using the ADC 13 and then post-processed in the control board 14 and then displayed on the screen of the computing device 3 or of the console 4. In implementations with an analogue signal output, the control board 14 provides the information on frequencies f₁ and f₂ to allow the user to determine the power amplitude and frequency of the electromagnetic radiation signal.

Figure 4 shows possible components of the wireless EOM 30 in more detail. The EOM 30 is shown in a top view in the upper left corner, while the EOM is shown in a partial cross-sectional view in the upper right corner of Figure 4. The main components of the EOM 30 are the antenna 22, the transmission line 24 and the optical waveguide 23. In the present configuration, the optical waveguide is at least partially surrounded by a cladding 37, which may be made of silicon oxide or silicon nitride or preferably of another dielectric material. The optical waveguide and in particular its core may be made for example of lithium niobate (LiNbOs), lithium tantalate (LiTaOs), barium titanate (BaTiOs), or aluminium nitride (AIN). Lithium niobate is a synthetic salt consisting of niobium, lithium, and oxygen. Lithium niobate is a colourless solid, which is insoluble in water. It has a trigonal crystal system, which lacks inversion symmetry and displays ferroelectricity, the Pockels effect, the piezoelectric effect, non-linear optical polarizability, and photoelasticity. The Pockels effect, also known as the linear electro-optic effect, is a directionally dependent linear variation in the refractive index of an optical medium that occurs in response to the application of an electric field. It is to be noted that in this case, the optical waveguide forms a thickened portion in the region between the electrodes of the transmission line. This thickened portion may be considered to form the core of the optical waveguide where the electro-optic effect takes place. In Figure 4, the following abbreviations are used: L_{TL}: length of the transmission line, hₑₗ height or thickness of the electrode, wₑₗ: width of the electrode, h_{etch}: etching height, w_{wg}: width of the optical waveguide, Lₐₙₜ: length of the antenna, wₐₙₜ: width of the antenna, Lₐᵣₘ: length of an antenna arm, Wₐᵣₘ: width of an antenna arm, *θ*ₐ: angle of an antenna section with respect to a line orthogonal to the longitudinal axis of the transmission line or the optical waveguide.

The middle row of Figure 4 shows different example antennas that may be used in the EOM 30. The left-hand side of the middle row shows a dipole antenna, which is also used in the configuration shown in the upper left corner. The middle part of the middle row shows a bow tie antenna, and the right-hand side of Figure 4 shows LC antenna (also called a resonant circuit antenna), which could alternatively or in addition be used in the EOM. However, other types of antennas may equally be used.

The bottom part of Figure 4 shows an example configuration, where a plurality of antennas, which may be mutually of different types, forming an antenna array are arranged longitudinally along the optical waveguide 23. As is shown, the optical waveguide 23 in this configuration is a non-straight element and comprises at least two parallel or substantially parallel elongated straight or substantially straight sections (in this example three parallel elongated sections). Table 1 below shows some possible values for different EOM and antenna parameters.

**Table 1**

| | Name of the parameter | Possible range | Preferred range |
|---|---|---|---|
| Parameters of the transmission line and optical waveguide | L_{TL} | 0.1 - 10 mm | 0.25 - 4 mm |
| | gap | 2 - 10 µm | 2-5 µm |
| | Wₑₗ | 1 - 10 µm | 2 - 5 µm |
| | hₑₗ | 0.1 - 3 µm | 0.1 - 1 µm |
| | W_{wg} | 0.4 - 5 µm | 1 - 2 µm |
| | h_{etch} | 0.1 - 0.6 µm | 0.3 - 0.6 µm |
| Parameters of the dipole antenna | Wₐₙₜ | 1 - 10 µm | 2 - 5 µm |
| | Lₐₙₜ | 20 - 1000 µm | 50 - 500 µm |
| Parameters of the bow tie antenna | Wₐₙₜ | 20 - 1000 µm | 50 - 500 µm |
| | Lₐₙₜ | 20 - 1000 µm | 50 - 500 µm |
| | *θ*ₐₙₜ | 5 - 85 degrees | 30 - 60 degrees |
| Parameters of the LC antenna | Wₐᵣₘ | 20 - 1000 µm | 50 - 500 µm |
| | Lₐₙₜ | 20 - 1000 µm | 50 - 500 µm |
| | Wₐₙₜ | 1 - 10 µm | 2-5 µm |
| | Lₐᵣₘ | 10 - 500 µm | 25 - 250 µm |

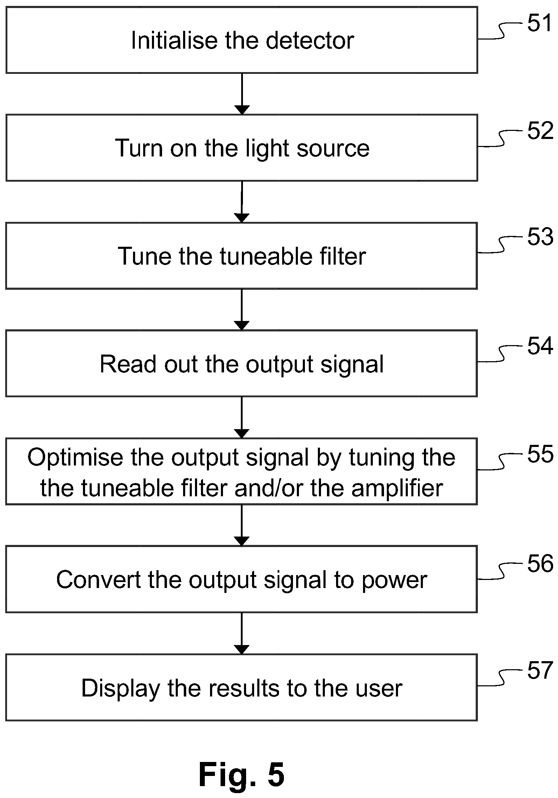

The flowchart of Figure 5 summarises the process of operating the detector 2 in the power meter mode when the output signal is a digital signal. In this mode, only one light source is used. In step 51, the detector 2 is initialised. This step may involve turning on the electrical power of all components, for example the control board, reading out the state of the light source 11₁ (e.g., the power of the optical radiation), the optical filter 31, the amplifier 35, and the optical detector 12. In step 52, the light source 11₁ is turned on to continuously emit optical radiation. In step 53, the state of the tuneable filter 31 is adjusted. More specifically, the filter is tuned to minimise the carrier frequency component of the optical radiation received from the light source. In step 54, the digital output signal is read out by the control board 14. In step 55, the output signal is optimised by tuning the tuneable filter 31 and/or the amplifier 35. This operation is controlled by the control board 14, i.e., the control board may automatically initiate the adjustments without any user intervention. In step 56, the output signal is converted to power indicating the power of the detected electromagnetic radiation. In step 57, the results are displayed to the user.

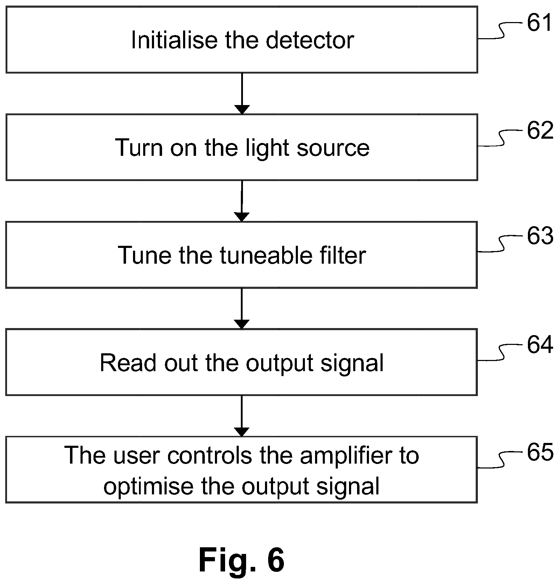

The flowchart of Figure 6 summarises the process of operating the detector 2 in the power meter mode when the output signal is an analogue signal. In this mode, only one light source is used. In step 61, the detector 2 is initialised. This step may involve reading out the state of the light source 11₁ (e.g., the power of the optical radiation), the optical filter 31, the amplifier 35, and the optical detector 12. In step 62, the light source 11₁ is turned on to continuously emit optical radiation. In step 63, the state of the tuneable filter 31 is adjusted. More specifically, the filter is tuned to minimise the carrier frequency component of the optical radiation received from the light source. In step 64, the analogue output signal is read out, in this case by the user. In step 65, the user controls through the user interface of the computing device 3 the output signal by tuning the amplifier 35. In this scenario, the user does not control the optical filter. The output signal, which in this case is a voltage signal, is proportional to the power of detected radiation. However, the exact conversion factor (in voltage/power) depends on the state of the amplifier 35. In other words, the device is calibrated for various amplifier states. If there is no amplifier, then the conversion factor in voltage/power is fixed.

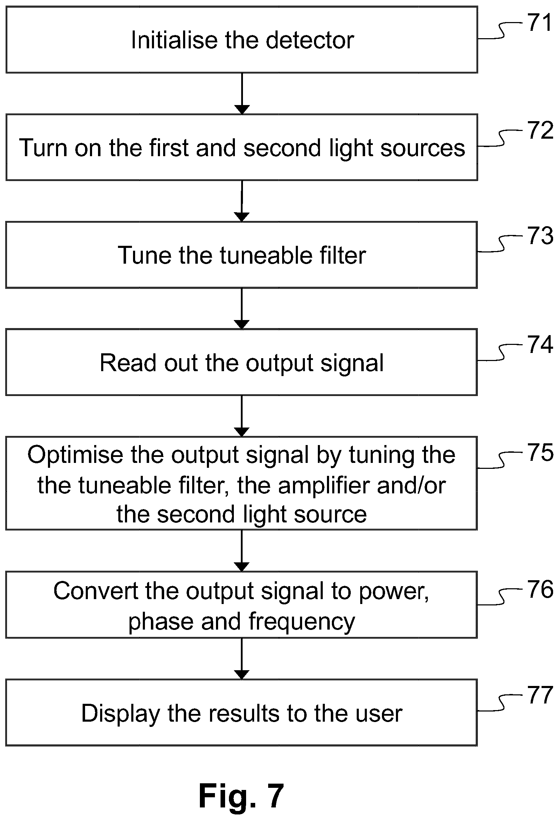

The flowchart of Figure 7 summarises the process of operating the detector 2 in the spectrometer mode when the output signal is a digital signal. In this mode, two light sources, namely the first light source 11₁ and the second light source 11₂, are used. In step 71, the detector 2 is initialised. This step may involve reading out the state of the light sources 11₁, 11₂ (e.g., the power of the optical radiation and its wavelength), the optical filter 31, the amplifier 35, and the optical detector 12. In step 72, the first and second light sources 11₁, 11₂ are turned on to continuously emit optical radiation, but at mutually different frequencies. In step 73, the state of the tuneable filter 31 is adjusted. More specifically, the filter is tuned to minimise the carrier frequency component of the optical radiation received from the first light source 11₁. In step 74, the digital output signal is read out by the control board 14. In step 75, the output signal is optimised by tuning the tuneable filter 31, the amplifier 35, and/or the second light source 11₂. This operation is controlled by the control board 14, i.e., the control board may automatically initiate the adjustments without any user intervention. In step 76, the output signal is converted to power, phase and frequency indicating the power, phase and frequency of the detected electromagnetic radiation. In step 77, the results are displayed to the user.

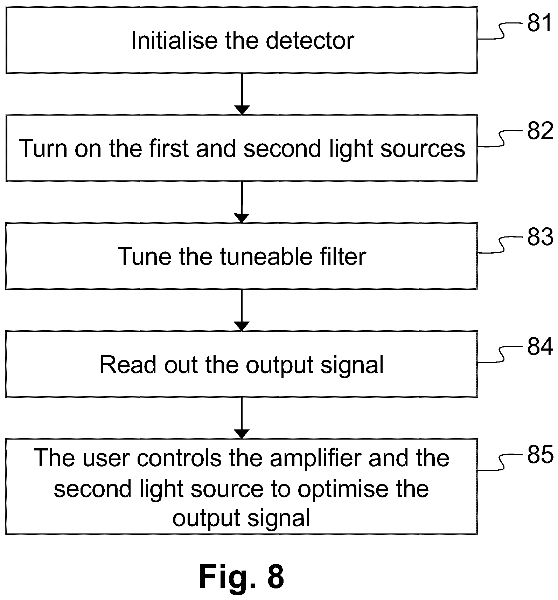

The flowchart of Figure 8 summarises the process of operating the detector 2 in the spectrometer meter mode when the output signal is an analogue signal. In this mode, two light sources, namely the first light source 11₁ and the second light source 11₂, are used. In step 81, the detector 2 is initialised. This step may involve reading out the state of the first and second light sources 11₁, 11₂ (e.g., the power of the optical radiation and its wavelength), the optical filter 31, the amplifier 35, and the optical detector 12. In step 82, the first and second light sources are turned on to continuously emit optical radiation, but at mutually different frequencies. In step 83, the state of the tuneable filter 31 is adjusted. More specifically, the filter is tuned to minimise the carrier frequency component of the optical radiation received from the first light source 11₁. In step 84, the analogue output signal is read out. In step 85, the user controls through the user interface of the computing device 3 the output signal by tuning the amplifier 35 and/or the second light source 11₂. In this scenario, the user does not control the optical filter. The output signal, which in this case is a voltage signal, is proportional to the power of detected radiation. However, the exact conversion factor (in voltage/power) depends on the state of the amplifier 35. In other words, the device is calibrated for various amplifier states. If there is no amplifier, then the conversion factor in voltage/power is fixed. Furthermore, depending on the states of the first and second light sources 11₁, 11₂, the relation between the measured voltage frequency and the frequency of the detected radiation may be given to the user.

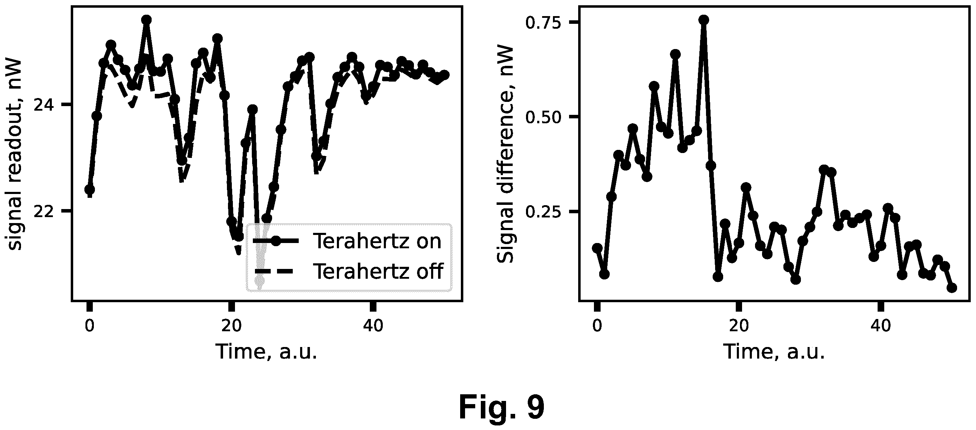

Figure 9 shows some example experimental measurements, in which the photonic circuit 20 was continuously illuminated with terahertz radiation having a frequency of 300 GHz. The optical signal was thereby modulated, and the left plot in Figure 9 shows the difference in measured signal with and without the terahertz radiation. The difference between these two signals is shown in the right plot of Figure 9. This difference is proportional to the absolute terahertz power.

While the invention has been illustrated and described in detail in the drawings and foregoing description, such illustration and description are to be considered illustrative or exemplary and not restrictive, the invention being not limited to the disclosed embodiments. Other embodiments and variants are understood and can be achieved by those skilled in the art when carrying out the claimed invention, based on a study of the drawings, the disclosure and the appended claims. Further variants may be obtained by combining the teachings of any of the examples explained above.

In the claims, the word "comprising" does not exclude other elements or steps, and the indefinite article "a" or "an" does not exclude a plurality. The mere fact that different features are recited in mutually different dependent claims does not indicate that a combination of these features cannot be advantageously used. Any reference signs in the claims should not be construed as limiting the scope of the invention.

## Claims

1. An electromagnetic radiation detector (2) comprising:
- a first light source (11₁) for emitting optical radiation;
- an electro-optic modulator (20) exposed to an electromagnetic radiation to be detected and configured to receive optical radiation emitted by the first light source (11₁), the electro-optic modulator (20) comprising at least a first antenna (22) for collecting the electromagnetic radiation, an optical waveguide (23) extending at least partially through the electro-optic modulator (20) to allow the optical radiation to propagate therethrough, and a set of electrodes (24) extending along the optical waveguide (23) and coupled at least to the first antenna (22) to enable an electro-optic effect to take place in the optical waveguide (23) such that the electromagnetic radiation modulates the optical radiation propagating in the optical waveguide (23); and
- an optical detector (12) configured to receive the modulated optical radiation and convert the modulated optical radiation into an electrical signal allowing at least power of the detected electromagnetic radiation to be directly or indirectly determined,
wherein the first light source (11₁) is configured to emit continuous-wave optical radiation.

2. The detector (2) according to claim 1, wherein the optical waveguide (23) is at least partially made of LiNbO₃, LiTaOs, BaTiOs, and/or AIN.

3. The detector (2) according to claim 1 or 2, wherein the electro-optic modulator (20) is an integrated photonic circuit, and/or wherein the detector (2) forms or is part of an integrated circuit forming a hand-held portable device.

4. The detector (2) according to any one of the preceding claims, wherein the detected electromagnetic radiation is free-space micrometre-wave, millimetre-wave or terahertz radiation.

5. The detector (2) according to any one of the preceding claims, wherein the detector (2) further comprises an analogue-to-digital converter (13) for converting the electrical signal into a digital signal.

6. The detector (2) according to any one of the preceding claims, wherein the detector (2) further comprises a signal filter (31), wherein the signal filter (31) is an optical filter or an electronic filter, and wherein the signal filter is optionally a tuneable filter.

7. The detector (2) according to claim 6, wherein the signal filter (31) is comprised in the electro-optic modulator (20).

8. The detector (2) according to any one of the preceding claims, wherein the detector (2) further comprises a signal amplifier (35) for amplifying the modulated optical radiation.

9. The detector (2) according to any one of the preceding claims, wherein the detector (2) further comprises a second light source (11₂) for emitting optical radiation arranged to be received by the optical detector (12), wherein the optical radiation emitted by the first light source (11₁) is **characterised by** a first signal frequency, and the optical radiation emitted by the second light source (11₂) is **characterised by** a second signal frequency, and wherein the first and second signal frequencies are mutually different.

10. The detector (2) according to any one of claims 6 to 9, wherein the detector (2) further comprises a control board (14) for controlling the operational state of any one of the signal filter (31), the signal amplifier (35), and the second light source (11₂).

11. The detector (2) according to any one of the preceding claims, wherein the first and/or the second light sources (11₁, 11₂) are laser light sources, and/or wherein the electrodes (24) have a length along the waveguide (23) comprised in the range of 0.1 mm to 10 mm, or more specifically in the range of 0.25 mm to 4 mm.

12. The detector (2) according to any one of the preceding claims, wherein the detector (2) comprises a plurality of antennas (22) arranged along the optical waveguide (23) such that respective two electrodes (24) are coupled to a respective antenna (22), and wherein the optical waveguide (23) in the electro-optic modulator (20) optionally comprises at least two substantially parallel elongated sections.

13. A method of operating an electromagnetic radiation detector (2) comprising:
- a first light source (11₁) for emitting optical radiation;
- an electro-optic modulator (20) exposed to an electromagnetic radiation to be detected and configured to receive optical radiation emitted by the first light source (11₁), the electro-optic modulator (20) comprising at least a first antenna (22) for collecting the electromagnetic radiation, an optical waveguide (23) extending at least partially through the electro-optic modulator (20) to allow the optical radiation to propagate therethrough, and a set of electrodes (24) extending along the optical waveguide (23) and coupled at least to the first antenna (22) to enable an electro-optic effect to take place in the optical waveguide (23) such that the electromagnetic radiation modulates the optical radiation propagating in the optical waveguide (23);
- an optical detector (12) configured to receive the modulated optical radiation and convert the modulated optical radiation into an electrical signal allowing at least power of the detected electromagnetic radiation to be directly or indirectly determined,
wherein the method comprises:
- initialising (51, 61, 71, 81) the detector (2);
- turning on (52, 62, 72, 82) the first light source (11₁) to thereby emit continuous-wave optical radiation; and
- reading out (54, 64, 74, 84) the electrical signal as processed or unprocessed to allow at least power of the detected electromagnetic radiation to be directly or indirectly determined.

14. The method according to claim 13, wherein the detector (2) further comprises a tuneable signal filter (31), wherein the method further comprises adjusting (53, 63, 73, 83) the operational state of the tuneable filter (31) prior to reading out and/or after having read out the electrical signal as processed or unprocessed.

15. The method according to claim 13 or 14, wherein the detector (2) further comprises a second light source (11₂) for emitting optical radiation arranged to be received by the optical detector (12), wherein the optical radiation emitted by the first light source (11₁) is **characterised by** a first signal frequency, and the optical radiation emitted by the second light source (11₂) is **characterised by** a second signal frequency, wherein the first and second signal frequencies are mutually different, wherein the method further comprises turning on (72, 82) the second light source (11₂) to emit continuous-wave optical radiation prior to reading out the electrical signal as processed or unprocessed, and wherein the method further comprises deriving the frequency of the detected electromagnetic radiation from the difference between the second and first frequencies, and deriving the power of the detected electromagnetic radiation from the amplitude of a beating signal, the frequency of which is dependent upon the difference between the second and first frequencies.
